# EUROPEAN PATENT APPLICATION

(11) **EP 4 672 869 A1**
(43) Date of publication of application: **31.12.2025**
(21) Application number: 25184656.4
(22) Date of filing: 23.06.2025
(51) Int. Cl.: H05H 7/22, H05H 7/18

(54) **DETECTING ARCING EVENTS WITHIN A LINEAR ACCELERATOR**

(30) Priority: 28.06.2024 CN 202410865091
(71) Applicant: Elekta Limited, Crawley West Sussex RH10 9BL (GB)
(72) Inventor: PANG, Hong, Beijing (CN); JIANG, Hongping, Beijing (CN); YUE, Caijin, Beijing (CN); LIU, Ge, Beijing (CN)
(74) Representative: Haseltine Lake Kempner LLP

(57) **Abstract**

Methods and systems for detecting arcing events within linear accelerators are disclosed herein. Arcing is detected within a linear accelerator using a reflected RF power signal. Such methods can be performed automatically using components of the linear accelerator itself. The method comprises obtaining a reflected RF power signal, detecting an anomaly based on the reflected RF power signal, the anomaly being indicative of the occurrence of an arcing event, and outputting a signal indicating an arcing event has occurred.

## Description

### Field of the Invention

Embodiments of the present invention described herein relate to methods and systems for detecting arcing events within radiotherapy linear accelerators (linacs). More specifically, the present invention relates to methods of detecting an arcing event within a radiotherapy linac, computer programs and non-transitory computer-readable mediums configured to execute said methods, and a radiotherapy linac system.

### Background of the Invention

Linear accelerators (linacs) have a wide range of applications in medicine and industry due to their ability to accelerate charged particles to high energies. In medicine they are critical for advanced cancer treatments through various forms of radiotherapy. In industry, they are invaluable for non-destructive testing, sterilization, and supporting cutting-edge research in particle physics and other scientific disciplines. Radiotherapy can be described as the use of ionising radiation, such as X-rays, to treat a human or animal body. Radiotherapy is commonly used to treat tumours within the body of a human or animal patient, or subject. In such treatments, ionising radiation is used to irradiate, and thus destroy or damage, cells which form part of the tumour.

Linacs are widely used in radiotherapy to deliver high-energy X-ray or electron beams to tumours with precision. The linacs used for radiotherapy are highly complex machines having a significant number of complex interacting subsystems. A beam generation module (BGM) is a subsystem used to generate the X-ray or electron beams. A BGM system comprises a high voltage generator (radiofrequency (RF) modulator), a magnetron, RF wave transmission, an electron gun and an accelerating waveguide. The RF modulator, electron gun and magnetron work with kilovolt voltages, while the RF wave transmitting in waveguide may have megavolt electric fields. Different approaches are employed to avoid short circuits, such as vacuum and high-pressure isolation gas SF6. However, arcing is still a common issue in BGM systems and may be caused by contamination on the surfaces of components, imperfections on the surfaces of components, component defects, component aging, poor vacuum quality and/or misalignment between components. When arcing occurs, it may lead to linac downtime and even damage to components.

Improved methods and systems for detecting arcing within linacs are desirable.

### Summary of the Invention

It is an aim of the present disclosure to at least partially address one or more of the challenges mentioned above. The invention is defined in the independent claims, to which reference should now be made. Further features are set out in the dependent claims.

According to a first aspect of the invention, there is provided a method of detecting an arcing event within a radiotherapy linear accelerator, linac, the method comprising: obtaining a reflected radiofrequency, RF, power signal; detecting an anomaly based on the reflected RF power signal, the anomaly being indicative of the occurrence of an arcing event; and outputting a signal indicating an arcing event has occurred.

Several advantages are obtained from embodiments according to the above-described aspect and aspects described below. Advantages of embodiments of the present invention include providing different ways to detect arcing within a linac automatically using components of the linac itself. This is advantageous as there is no need for additional monitoring equipment such as an oscilloscope. Further, when oscilloscopes are used to monitor signals from the linac, this is done manually, requiring a skilled engineer to monitor the oscilloscope and manually flag any anomalies seen. This also is a subjective test, it depends on the skill and experience of the engineer. In contrast, embodiments of the present invention can be performed automatically using components within the linac. This means no additional equipment or personnel is required to detect arcing, and the test is objective.

In some embodiments, the linac comprises one or more modules, and the method is performed automatically by the one or more modules of the linac.

In some embodiments, the anomaly indicative of the occurrence of the arcing event is detected based on an amplitude of the reflected RF power signal.

In some embodiments, the method further comprises monitoring an average value of an amplitude of the reflected RF power signal, and wherein the anomaly indicative of the occurrence of the arcing event is detected based on the monitored average value.

In some embodiments, the method further comprises monitoring a first-order difference of the reflected RF power signal, and wherein the anomaly indicative of the occurrence of the arcing event is detected based on the monitored first-order difference.

In some embodiments, the method further comprises: obtaining a forward RF power signal; and obtaining a signal indicative of a phase difference between the forward RF power signal and the reflected RF power signal; wherein the anomaly indicative of the occurrence of the arcing event is detected based on the signal indicative of the phase difference.

In some embodiments, the method further comprises monitoring an average value of an amplitude of the signal indicative of the phase difference, and wherein the anomaly indicative of the occurrence of the arcing event is detected based on the monitored average value.

In some embodiments, the method further comprises: obtaining a forward RF power signal; obtaining a signal indicative of a phase difference between the forward RF power signal and the reflected RF power signal; and monitoring a first-order difference of the signal indicative of the phase difference, and wherein the anomaly indicative of the occurrence of the arcing event is detected based on the first-order difference.

In some embodiments, the first-order difference comprises a difference between the signal indicative of the phase difference at time n, and the signal indicative of the phase difference at time n-1.

In some embodiments, the method further comprising inputting the reflected RF power signal and the forward RF power signal into a discriminator, which processes the reflected RF power signal and the forward RF power signal and outputs a first output signal and a second output signal; wherein the signal indicative of the phase difference is obtained by calculating a difference between the second output signal and the first output signal.

In some embodiments, the detecting of the anomaly indicative of the occurrence of the arcing event in the signal indicative of the phase difference comprises: inputting the first and second output signals into a differential circuit to obtain a jump signal; and determining that an amplitude of the jump signal exceeds a predetermined threshold.

In some embodiments, the arcing event comprises arcing in a RF power transmission path of the linac.

In some embodiments, the signal indicating an arcing event has occurred is output to a user.

According to a second aspect, there is provided a computer program product comprising a computer readable medium, the computer readable medium having computer readable code embodied therein, the computer readable code being configured such that, on execution by a suitable computer or processor, the computer or processor is caused to perform any embodiment described above.

According to a third aspect, there is provided a non-transitory computer-readable storage medium comprising instructions, which, when executed by a computer, cause the computer to execute any embodiment described above.

According to a fourth aspect, there is provided a radiotherapy linear accelerator, linac, system comprising one or more modules collectively configured to perform the method of any embodiment described above.

According to a fifth aspect, there is provided a radiotherapy linear accelerator, linac, system comprising one or more modules collectively configured to: obtain a reflected radiofrequency, RF, power signal; detect an anomaly based on the reflected RF power signal, the anomaly being indicative of the occurrence of an arcing event; and output a signal indicating an arcing event has occurred.

In some embodiments, the one or more modules comprise a reflected RF signal probe configured to obtain the reflected RF power signal.

In some embodiments, the one or more modules further comprise a forward RF signal probe configured to obtain a forward RF power signal.

In some embodiments, the one or more modules further comprise a discriminator, an amplifier and a controller; and wherein: the forward RF signal probe and the reflected RF signal probe are configured to send the forward RF power signal and the reflected RF power signal to the discriminator; the discriminator is configured to process the forward RF power signal and the reflected RF power signal and output a first output signal and a second output signal; the amplifier is configured to calculate a difference between the second output signal and the first output signal to obtain a signal indicative of the phase difference between the forward RF power signal and the reflected RF power signal, and to output the signal indicative of the phase difference to the controller; the controller is configured to detect the anomaly indicative of the occurrence of the arcing event in the signal indicative of the phase difference, and to output the signal indicating an arcing event has occurred.

In some embodiments, the one or more modules further comprise a differential circuit, and wherein: the differential circuit is configured to receive the first and second output signals from the discriminator and obtain a jump signal; and the controller is configured to receive the jump signal from the differential circuit and determine that an amplitude of the jump signal exceeds a predetermined threshold.

In some embodiments, the controller is a microcontroller unit, MCU.

In some embodiments, the controller is a beam generation controller of the linac.

Other features of the disclosure are described below and recited in the appended claims.

The invention may be implemented in digital electronic circuitry, or in computer hardware, firmware, software, or in combinations thereof. The invention may be implemented as a computer program or a computer program product, i.e., a computer program tangibly embodied in a non-transitory information carrier, e.g., in a machine-readable storage device or in a propagated signal, for execution by, or to control the operation of, one or more hardware modules.

A computer program may be in the form of a stand-alone program, a computer program portion, or more than one computer program, and may be written in any form of programming language, including compiled or interpreted languages, and it may be deployed in any form, including as a stand-alone program or as a module, component, subroutine, or other unit suitable for use in a data processing environment.

The invention is described in terms of particular embodiments. Other embodiments are within the scope of the following claims. For example, the steps of the invention may be performed in a different order and still achieve desirable results.

Elements of the invention have been described using the terms "processor" etc. The skilled person will appreciate that such functional terms and their equivalents may refer to parts of the system that are spatially separate but combine to serve the function defined. Equally, the same physical parts of the system may provide two or more of the functions defined. For example, separately defined means may be implemented using the same memory and/or processor as appropriate.

### Brief Description of the Drawings

Embodiments of the invention will now be further described by way of example only and with reference to the accompanying drawings, wherein like reference numerals refer to like parts, and wherein:
Figure 1 shows a radiotherapy system, suitable for use with embodiments of the invention.
Figure 2 shows a radiotherapy system, suitable for use with embodiments of the invention.
Figure 3 shows an example beam generation module (BGM) of a linac, suitable for use with embodiments of the invention.
Figure 4 shows an example of components used to monitor a reflected RF wave, in accordance with embodiments of the invention.
Figure 5 shows example CT (magnetron current), CVD (magnetron voltage), e-gun current and RF reflected waveforms when arcing is not occurring.
Figure 6 shows example CT (magnetron current), CVD (magnetron voltage), e-gun current and RF reflected waveforms when arcing is occurring.
Figure 7 is an example discriminator, suitable for use with embodiments of the invention.
Figure 8 shows an example of a typical AFC error curve.
Figure 9 shows an example of components used to monitor the phase error, in accordance with embodiments of the invention.
Figure 10 shows example AFC A, AFC B and (AFC A - AFC B) signals when arcing is occurring.
Figure 11 shows example AFC A, AFC B and (AFC A - AFC B) signals when intentional dissonance is occurring.
Figure 12 shows an example of components used to obtain a jump signal, in accordance with embodiments of the invention.
Figure 13 is a flow chart of a method of detecting an arcing event within a linac, in accordance with embodiments of the invention.
Figure 14 is a flow chart of a method of detecting an arcing event within a linac, in accordance with embodiments of the invention.
Figure 15 is a flow chart of a method of detecting an arcing event within a linac, in accordance with embodiments of the invention.
Figure 16 is a flow chart of a method of detecting an arcing event within a linac, in accordance with embodiments of the invention.

### Detailed Description

### Overview

Embodiments of the present invention provide different ways to detect arcing within a linac automatically using components of the linac itself. This is advantageous as there is no need for additional monitoring equipment such as an oscilloscope. Further, when oscilloscopes are used to monitor signals from the linac, this is done manually, requiring a skilled engineer to monitor the oscilloscope and manually flag any anomalies seen. In contrast, embodiments of the present invention can be performed automatically using a discriminator and the BGC, which are already components within a linac. This means no additional equipment or personnel is required to detect arcing. A first way involves monitoring the amplitude of the reflected RF signal. A second way involves monitoring the amplitude of the phase error signal (derived from the forward and reflected RF signals). A third way involves monitoring d(n)-d(n-1), which may be referred to as a first-order difference, where d is the phase error signal and n indicates time. As such, all three ways provide methods for detecting arcing using the reflected RF signal.

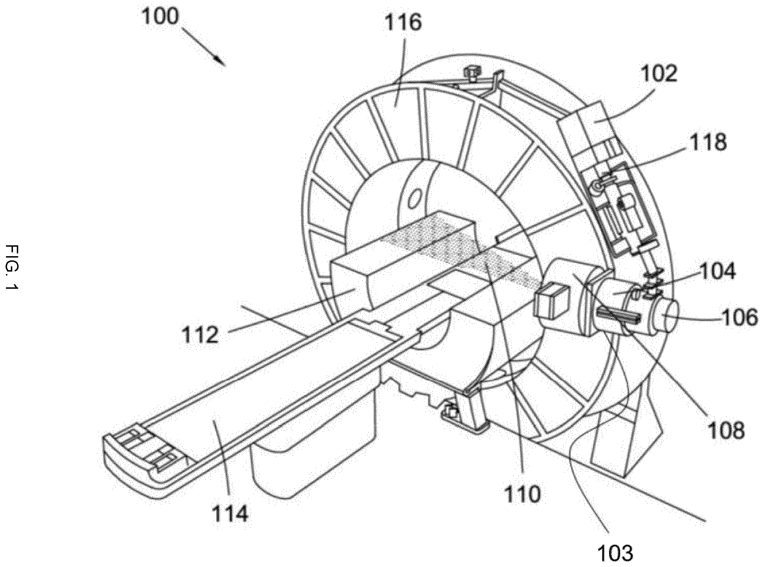

Various aspects and details of these principal concepts will be described below with reference to Figures 1 to 16.

### Radiotherapy System

Figure 1 shows a radiotherapy system, or device, suitable for delivering, and configured to deliver, a beam of radiation to a patient during radiotherapy treatment. The device and its constituent components will be described generally for the purpose of providing useful accompanying information for the present disclosure. The device shown in Figure 1 is in accordance with the present disclosure and is suitable for use with the disclosed methods and systems. While the device in Figure 1 is an MR-linac (magnetic resonance linear accelerator), the implementations of the present disclosure may be any linac (linear accelerator) device.

The device 100 shown in Figure 1 is an MR-linac. The device 100 comprises both MR imaging apparatus 112 and radiotherapy (RT) apparatus which may comprise a linac device. The MR imaging apparatus 112 is shown in the diagram in a partially cut away perspective manner. In operation, the MR scanner produces MR images of the patient, and the linac device produces and shapes a beam of radiation and directs it towards a target region within a patient's body in accordance with a radiotherapy treatment plan. Figure 1 does not show the usual 'housing' which would cover the MR imaging apparatus 112 and RT apparatus in a commercial setting such as a hospital.

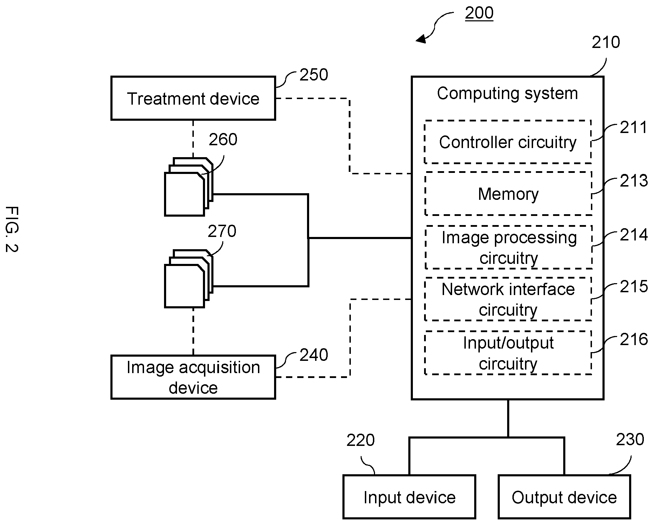

The MR-linac device shown in Figure 1 comprises a source 102 of radiofrequency (RF) waves, a waveguide 104, an electron source 106, a radiation source 103, a collimator 108 such as a multi-leaf collimator configured to collimate and shape the beam, MR imaging apparatus 112 (shown partially cut away), and a patient support surface 114. In use, the device would also comprise a housing (not shown) which, together with the ring-shaped gantry, defines a bore. The patient support surface 114 is moveable and can be used to support a patient and move them, or another subject, into the bore when an MR scan and/or when radiotherapy is to commence. The MR imaging apparatus 112, RT apparatus, and a patient support surface actuator are communicatively coupled to a controller 211 or processor. The controller is also communicatively coupled to a memory device 213 comprising computer-executable instructions which may be executed by the controller (see Figure 2 described below). The controller may be referred to below as a beam generation controller (BGC).

The RT apparatus comprises a radiation source 103 and a radiation detector (not shown). Typically, the radiation detector is positioned diametrically opposed to the radiation source 103. The radiation detector is suitable for, and configured to, produce radiation intensity data. In particular, the radiation detector is positioned and configured to detect the intensity of radiation which has passed through the subject. The radiation detector may also be described as radiation detecting means and may form part of a portal imaging system.

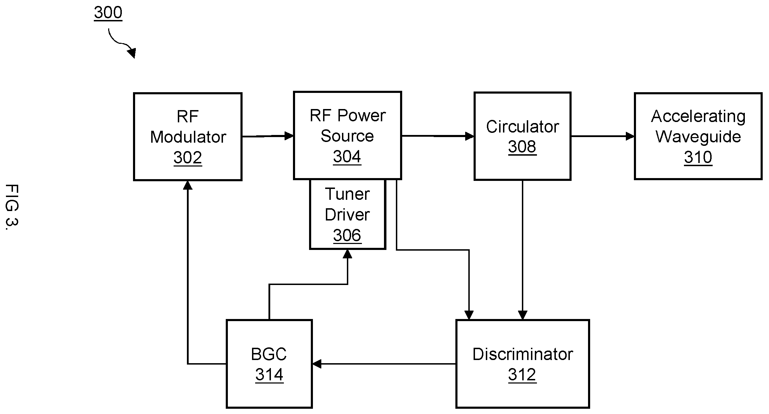

The radiation source 103 may comprise a beam generation module (BGM) or system. The layout of the BGM will be described in greater detail below with reference to Figure 3. For a linac, the beam generation system may comprise a source 102 of RF waves, an electron source 106 such as an electron gun (or e-gun), and a waveguide 104. The radiation source 103 is attached to the rotatable gantry 116 so as to rotate with the gantry 116. In this way, the radiation source 103 is rotatable around the patient so that a treatment beam 110 can be applied from different angles around the gantry 116. In a preferred implementation, the gantry is continuously rotatable. In other words, the gantry can be rotated by 360 degrees around the patient, and in fact may continue to be rotated past 360 degrees. The gantry may be ring-shaped. In other words, the gantry may be a ring-gantry.

The source 102 of radiofrequency waves, such as a magnetron, is configured to produce radiofrequency waves. The source 102 of radiofrequency waves is coupled to the waveguide 104 via a circulator 118 and is configured to pulse radiofrequency waves into the waveguide 104. Radiofrequency waves may pass from the source 102 of radiofrequency waves through an RF input window and into an RF input connecting pipe or tube. The electron source 106 is also coupled to the waveguide 104 and is configured to inject electrons into the waveguide 104. In the electron source 106, electrons are thermionically emitted from a cathode as its filament is heated. The temperature of the filament controls the number of electrons injected. The injection of electrons into the waveguide 104 is synchronised with the pumping of the radiofrequency waves into the waveguide 104. The design and operation of the source 102 of radiofrequency waves, the electron source 106 and the waveguide 104 is such that the radiofrequency waves accelerate the electrons to very high energies as the electrons propagate through the waveguide 104.

The design of the waveguide 104 depends on whether the linac accelerates the electrons using a standing wave or travelling wave, though the waveguide typically comprises a series of cells or cavities, each cavity connected by a hole or 'iris' through which the electron beam may pass. The cavities are coupled in order that a suitable electric field pattern is produced which accelerates electrons propagating through the waveguide 104. As the electrons are accelerated in the waveguide 104, the electron beam path is controlled by a suitable arrangement of steering magnets, or steering coils, which surround the waveguide 104. The arrangement of steering magnets may comprise, for example, two sets of quadrupole magnets.

Once the electrons have been accelerated, they may pass into a flight tube. The flight tube may be connected to the waveguide by a connecting tube. This connecting tube or connecting structure may be called a drift tube. The electrons travel toward a heavy metal target which may comprise, for example, tungsten. Whilst the electrons travel through the flight tube, an arrangement of focusing magnets act to direct and focus the beam on the target.

To ensure that propagation of the electrons is not impeded as the electron beam travels toward the target, the waveguide 104 is evacuated using a vacuum system comprising a vacuum pump or an arrangement of vacuum pumps. The pump system is capable of producing ultrahigh vacuum (UHV) conditions in the waveguide 104 and in the flight tube. The vacuum system also ensures UHV conditions in the electron gun. Electrons can be accelerated to speeds approaching the speed of light in the evacuated waveguide 104.

The radiation source 103 is configured to direct the treatment beam 110 of therapeutic radiation toward a patient positioned on the patient support surface 114. The radiation source 103 may therefore also be referred to as a therapeutic radiation source. The radiation source 103 may comprise a heavy metal target towards which the high energy electrons exiting the waveguide are directed. When the electrons strike the target, X-rays are produced in a variety of directions. A primary collimator may block X-rays travelling in certain directions and pass only forward travelling X-rays to produce the treatment beam 110. The X-rays may be filtered and may pass through a primary ion chamber and a secondary ion for dose measuring. The beam can be shaped in various ways by beam-shaping apparatus, for example by using the multi-leaf collimator 108, before it passes into the patient as part of radiotherapy treatment.

In some implementations, the radiation source 103 is configured to emit either an X-ray beam or an electron particle beam. Such implementations allow the device to provide electron beam therapy, i.e. a type of external beam therapy where electrons, rather than X-rays, are directed toward the target region as the therapeutic radiation. It is possible to 'swap' between a first mode in which X-rays are emitted and a second mode in which electrons are emitted by adjusting the components of the linac. In essence, it is possible to swap between the first and second mode by moving the heavy metal target in or out of the electron beam path and replacing it with a so-called 'electron window'. The electron window is substantially transparent to electrons and allows electrons to exit the flight tube.

The subject or patient support surface 114 is configured to move between a first position substantially outside the bore, and a second position substantially inside the bore. In the first position, a patient or subject can mount the patient support surface. The patient support surface 114, and patient, can then be moved inside the bore, to the second position, for the patient to be imaged by the MR imaging apparatus 112 and/or imaged or treated using the RT apparatus. The bore may hence lie about a portion of space that is suitable for receiving at least a portion of a patient - a patient receiving space. The movement of the patient support surface is affected and controlled by a patient support surface actuator, which may be described as an actuation mechanism. Together, these components may be described as a patient positioning system, which may comprise other components. The actuation mechanism is configured to move the patient support surface in a direction parallel to, and defined by, the central axis of the bore. The terms subject and patient are used interchangeably herein such that the patient support surface can also be described as a subject support surface. The patient support surface may also be referred to as a moveable or adjustable couch or table.

The radiotherapy apparatus/device shown in Figure 1 also comprises an optional MR imaging apparatus 112. The MR imaging apparatus 112 is configured to obtain images of a subject positioned, i.e. located, on the patient support surface 114. The MR imaging apparatus 112 may also be referred to as the MR imager. The MR imaging apparatus 112 may be a conventional MR imaging apparatus operating in a known manner to obtain MR data, for example MR images. The skilled person will appreciate that such an MR imaging apparatus 112 may comprise a primary magnet, one or more gradient coils, one or more receive coils, and an RF pulse applicator. The operation of the MR imaging apparatus is controlled by the controller.

The controller is a computer, processor, or other processing apparatus. The controller may be formed by several discrete processors; for example, the controller may comprise an MR imaging apparatus processor, which controls the MR imaging apparatus 112; an RT apparatus processor (which may be referred to below as a beam generation controller (BGC)), which controls the operation of the RT apparatus; and a subject support surface processor which controls the operation and actuation of the patient support surface. The controller is communicatively coupled to a memory, e.g. a computer readable medium. The controller may be the computing system 210 described below in relation to Figure 2.

The linac device also comprises several other components and systems as will be understood by the skilled person. For example, to ensure the linac does not leak radiation, appropriate shielding is also provided.

Each time a dose of radiotherapy is to be given to a patient positioned on the patient support surface a trigger signal or signals cause a dose of radiation to be emitted from the radiation source. The trigger signal or signals is/are simultaneously provided to a plurality of parts of the radiotherapy system 100 in order for that to occur. Parts of the radiotherapy system 100 that are so simultaneously triggered may include the magnetron and the electron gun. The simultaneous triggering of various parts of the radiotherapy system 100 will also trigger a number of pulse signals that may be observed in order to assess performance of the radiotherapy system. Examples of such observable pulse signals include: a magnetron current signal (CT), a magnetron voltage signal (CVD), an electron gun current signal, an RF forward power signal, an RF reflected power signal, a primary ion chamber current, and a secondary ion chamber current. Such simultaneously triggered signals will have a common nominal pulse width (for example 5µS) and the nominal pulse width can be used to determine a data capture window for capturing data associated with a given pulse. As one example, the data capture window could be slightly larger than the nominal pulse width to ensure that all data associated with a given pulse can be captured.

The radiotherapy system 100 may be operated according to a sequence, or series, of groups of synchronously triggered pulses, with each different type of pulse signal within the group being triggered synchronously with the same repetition frequency.

### Computing System

Figure 2 is a block diagram of an implementation of a radiotherapy system 200, suitable for executing methods according to embodiments. The example radiotherapy system 200 comprises a computing system 210 within which a set of instructions, for causing the computing system 210 to perform the method (or steps thereof) discussed herein, may be executed. The computing system 210 may optionally implement an image reconstruction system. The computing system 210 may also be referred to as a computer. In particular, the methods described herein may be implemented by a processor or controller circuitry 211 of the computing system 210.

The computing system 210 shall be taken to include any number or collection of machines, e.g., computing device(s), that individually or jointly execute a set (or multiple sets) of instructions to perform any one or more of the methods discussed herein. That is, hardware and/or software may be provided in a single computing device, or distributed across a plurality of computing devices in the computing system. In some implementations, one or more elements of the computing system may be connected (e.g., networked) to other machines, for example in a Local Area Network (LAN), an intranet, an extranet, or the Internet. One or more elements of the computing system may operate in the capacity of a server or a client machine in a client-server network environment, or as a peer machine in a peer-to-peer (or distributed) network environment. One or more elements of the computing system may be a personal computer (PC), a tablet computer, a set-top box (STB), a Personal Digital Assistant (PDA), a cellular telephone, a web appliance, a server, a network router, switch or bridge, or any machine capable of executing a set of instructions (sequential or otherwise) that specify actions to be taken by that machine.

The computing system 210 includes controller circuitry 211 and a memory 213 (e.g., read-only memory (ROM), flash memory, dynamic random access memory (DRAM) such as synchronous DRAM (SDRAM) or Rambus DRAM (RDRAM), etc.). The memory 213 may comprise a static memory (e.g., flash memory, static random access memory (SRAM), etc.), and/or a secondary memory (e.g., a data storage device), which communicate with each other via a bus (not shown).

Controller circuitry 211 represents one or more general-purpose processors such as a microprocessor, central processing unit, accelerated processing units, or the like. More particularly, the controller circuitry 211 may comprise a complex instruction set computing (CISC) microprocessor, reduced instruction set computing (RISC) microprocessor, very long instruction word (VLIW) microprocessor, processor implementing other instruction sets, or processors implementing a combination of instruction sets. Controller circuitry 211 may also include one or more special-purpose processing devices such as an application specific integrated circuit (ASIC), a field programmable gate array (FPGA), a digital signal processor (DSP), network processor, or the like. One or more processors of the controller circuitry may have a multicore design. Controller circuitry 211 is configured to execute the processing logic for performing the operations and steps discussed herein.

The computing system 210 may further include a network interface circuitry 215. The computing system 210 may be communicatively coupled to an input device 220 and/or an output device 230, via input/output circuitry 216. In some implementations, the input device 220 and/or the output device 230 may be elements of the computing system 210. The input device 220 may include an alphanumeric input device (e.g., a keyboard or touchscreen), a cursor control device (e.g., a mouse or touchscreen), an audio device such as a microphone, and/or a haptic input device. The output device 230 may include an audio device such as a speaker, a video display unit (e.g., a liquid crystal display (LCD) or a cathode ray tube (CRT)), and/or a haptic output device. In some implementations, the input device 220 and the output device 230 may be provided as a single device, or as separate devices.

In some implementations, the computing system 210 may comprise image processing circuitry 214. Image processing circuitry 214 may be configured to process image data 270 (e.g., images, imaging data, projections, projection data), such as medical images obtained from one or more imaging data sources, a treatment device 250 and/or an image acquisition device 240.

Image processing circuitry 214 may be configured to process, or pre-process, image data 270. For example, image processing circuitry 214 may convert received image data into a particular format, size, resolution or the like.

In some implementations, the radiotherapy system 200 may further comprise an image acquisition device 240 and/or a treatment device 250. The image acquisition device 240 and the treatment device 250 may be provided as a single device, e.g. system 100 described in relation to Figure 1 above. In some implementations, treatment device 250 is configured to perform imaging, for example in addition to providing treatment and/or during treatment.

Image acquisition device 240 may be configured to perform positron emission tomography (PET), computed tomography, magnetic resonance imaging (MRI), single positron emission computed tomography (SPECT), X-ray, and the like.

Image acquisition device 240 may be configured to output image data 270, which may be accessed by computing system 210. Treatment device 250 may be configured to output treatment data 260, which may be accessed by computing system 210. Treatment data 260 may be obtained from an internal data source (e.g., from memory 213) or from an external data source, such as treatment device 250 or an external database.

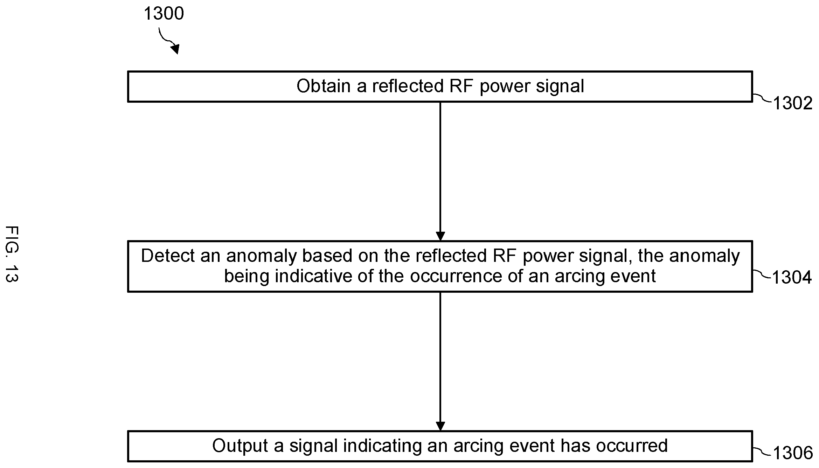

The various methods described below may be implemented by a computer program. The computer program may include computer code (e.g., instructions) arranged to instruct a computer to perform the functions of one or more of the various methods described below. For example, the steps of the methods described below in relation to any of Figures 13 to 16 may be performed by the computer code. The steps of the methods described below may be performed in any suitable order. The computer program and/or the code for performing such methods may be provided to an apparatus, such as a computer, on one or more computer readable media or, more generally, a computer program product. The computer readable media may be transitory or non-transitory. The one or more computer readable media could be, for example, an electronic, magnetic, optical, electromagnetic, infrared, or semiconductor system, or a propagation medium for data transmission, for example for downloading the code over the Internet. Alternatively, the one or more computer readable media could take the form of one or more physical computer readable media such as semiconductor or solid-state memory, magnetic tape, a removable computer diskette, a random access memory (RAM), a read-only memory (ROM), a rigid magnetic disc, and an optical disk, such as a CD-ROM, CD-R/W or DVD. The instructions may also reside, completely or at least partially, within the memory 213 and/or within the controller circuitry 211 during execution thereof by the computing system 210, the memory 213 and the controller circuitry 211 also constituting computer-readable storage media.

In an implementation, the modules, components and other features described herein may be implemented as discrete components or integrated in the functionality of hardware components such as ASICS, FPGAs, DSPs or similar devices.

A "hardware component" is a tangible (e.g., non-transitory) physical component (e.g., a set of one or more processors) capable of performing certain operations and may be configured or arranged in a certain physical manner. A hardware component may include dedicated circuitry or logic that is permanently configured to perform certain operations. A hardware component may comprise a special-purpose processor, such as an FPGA or an ASIC. A hardware component may also include programmable logic or circuitry that is temporarily configured by software to perform certain operations.

In addition, the modules and components may be implemented as firmware or functional circuitry within hardware devices. Further, the modules and components may be implemented in any combination of hardware devices and software components, or only in software (e.g., code stored or otherwise embodied in a machine-readable medium or in a transmission medium).

Unless specifically stated otherwise, as apparent from the following discussion, it is appreciated that throughout the description, discussions utilizing terms such as "detecting", "receiving", "transforming", "extracting", "obtaining", "determining", "enabling", "maintaining", "identifying", "inputting", "outputting", or the like, refer to the actions and processes of a computer system, or similar electronic computing device, that manipulates and transforms data represented as physical (electronic) quantities within the computer system's registers and memories into other data similarly represented as physical quantities within the computer system memories or registers or other such information storage, transmission or display devices.

### BGM System

As described above in relation to the radiotherapy system 100 of Figure 1, the radiation source 103 may comprise a BGM. The BGM is responsible for generating and delivering the electron beam or X-ray beam used in radiation therapy. A simplified BGM structure is shown in Figure 3 and is described below. The BGM system 300 comprises various components, each playing a crucial role in the generation, acceleration, control, and delivery of the particle beam. These components are described below.

An RF modulator 302 is arranged to provide initial pulses to the RF power source 304, e.g. a magnetron, and each pulse may in turn trigger the RF power source 304 to output or transmit a corresponding subsequent RF pulse towards the circulator 308.

It will be understood that each "initial pulse" described herein may be a pulse signal and may correspond to a voltage signal pulse or other electrical pulse. Such pulses may thus be used to control the operation of components such as the RF power source and the accelerating waveguide. For example, the RF power source may be triggered or modulated by a received initial pulse to output a pulse of RF power to the accelerating waveguide corresponding to the duration of the received initial pulse. Such pulse signals will have a nominal pulse width (for example 5µS) in the time domain corresponding to the operational requirements of the beam generation subsystem. Thus, in examples using a pulse width of 5µS, an electrical pulse of 5µS may be generated by the RF modulator 302 and provided to the RF power source 304, and the RF power source 304 may then output a pulse of RF power with a duration of 5µS. The RF power source may operate in this manner repeatedly and hence may output pulses according to a pulse repetition frequency, PRF. A typical PRF value for a radiotherapy system is 275 Hz, although other values may be used depending upon the system requirements.

The RF modulator 302 may be arranged to temporally modulate or control the output of the RF power source 304. For example, the RF modulator 302 may be arranged to generate initial pulses at a particular frequency (a pulse repetition frequency) and provide those pulses to the RF power source 304; the RF power source 304 will then generate subsequent RF pulses in accordance with that pulse repetition frequency, each pulse having the appropriate power or energy for powering an accelerating waveguide 310 of a beam generation subsystem. In some examples, the initial pulses may be pulses of RF energy or power, and further may be amplified by the RF power source 304. In some examples, the initial pulses are non-RF electrical signals.

The circulator 308 is arranged to transmit the subsequent RF pulses from the RF power source 304 towards an accelerating waveguide 310 of a linear accelerator. The circulator 308 thus provides a passive transmission component between the RF power source 304 and the accelerating waveguide 310. It will be appreciated that the RF modulator 302, RF power source 304, circulator 308, and accelerating waveguide 310 may each be coupled to adjacent RF component(s) as shown in Figure 3 by any suitable RF transmission medium, such as a waveguide. As will be known to those skilled in the art, typically a circulator used in radiotherapy has four ports, and those ports will be arranged in an appropriate manner for the beam generation subsystem. For example, while one of the ports may be arranged to receive RF power from the RF power source 304, another will be arranged to output RF power to the accelerating waveguide 310, while another two ports may be respectively connected to, for example, a water load and a dry load. It will be appreciated that, in some examples, a circulator having a different number of ports to four may be used as the circulator 308. The accelerating waveguide 310 accelerates electrons from an electron gun (not shown) using the RF power/energy. The accelerated electrons are then directed at a target (not shown). At the target, the kinetic energy of the electrons may be converted into other forms of energy, such as X-rays, for medical or industrial applications.

The RF modulator 302 may be controlled by an RF trigger signal received from a controller, which may be referred to as a beam generation controller (BGC) 314. The BGC 314 monitors and manages the system 300. The BGC 314 interfaces with various subsystems to control parameters, monitor performance and ensure safety. The BGC 314 may perform one or more steps of methods 1300, 1400, 1500, 1600, 1700 described below. The BGC 314 may receive inputs from and send outputs to a real-time computer (not shown). This real-time computer may be connected to a control PC comprising a web GUI. The web GUI may allow an engineer or a user to view outputs of the BGC 314 and input user input.

The BGC 314 may also manage the generation of the electron beam. The BGC may coordinate with a gun modulator (not shown) to produce a precise and stable electron stream. The gun modulator provides high-voltage pulses needed to extract electrons from an electron gun (not shown). The gun modulator ensures precise timing and control of the electron emission. The electron gun generates electrons that are then accelerated in the accelerating waveguide 310. The electron gun may comprise a thermionic or photocathode type, emitting electrons when heated or exposed to light.

A discriminator 312, e.g. an AFC (Automatic Frequency Control) discriminator, may receive a reflected RF signal from the circulator 308. The discriminator 312 also may receive a forward RF signal from the RF power source 304. The discriminator 312 maintains the stability of the magnetron RF frequency to ensure the RF energy remains at the optimal frequency for the accelerating waveguide 346 based on the forward RF signal and the reflected RF signal. The discriminator 312 may output a phase error signal back to the BGC 314. The operation of the discriminator 312 is described in greater detail below. A tuner driver 306 may be connected at the RF power source 304. The tuner driver 306 adjusts the RF power source's frequency to the resonant frequency of the accelerator to compensate for thermal and other variations to maintain optimal operation (this is described in more detail below). The tuner driver 306 may receive a tuner control signal from the BGC 314.

Arcing may occur in the RF power source 304 or the RF power transmission path (components and pathways involved in the transmission of RF energy from the RF source power 304 (e.g. magnetron) to the accelerating structures (accelerating waveguide 310)).

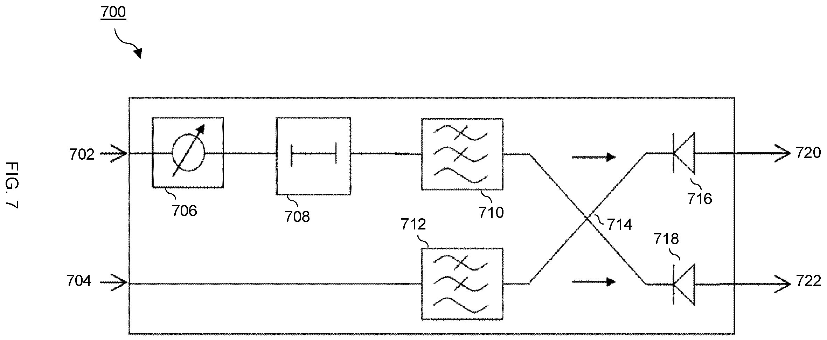

An example of a discriminator 312 is explained in more detail with respect to Figure 7 which shows an exemplary AFC module 700. Module 700 receives a forward RF signal 702 and a reflected RF signal 704. The forward signal 702 passes through a phase shifter 706, a delay line 708 and a first LP (low pass) filter 710. The reflected signal 704 passes through a second LP filter 712. The two signals are then coupled using a coupler 714. The reflected signal 704 passes through a first diode 716 to form a first output signal 720. The forward signal 702 passes through a second diode 718 to form a second output signal 722. The first output signal 720 may be referred to as AFC A. The second output signal 722 may be referred to as AFC B. The differential error signal AFC B - AFC A is proportional to the phase difference of the RF signals 702, 704. Generally, the discriminator 312 takes the forward RF signal from the RF power source 304 and the reflected RF signal from the circulator 308 and outputs two output signals. The difference between these output signals can be determined to give a differential error signal which is proportional to the phase difference of the RF signals.

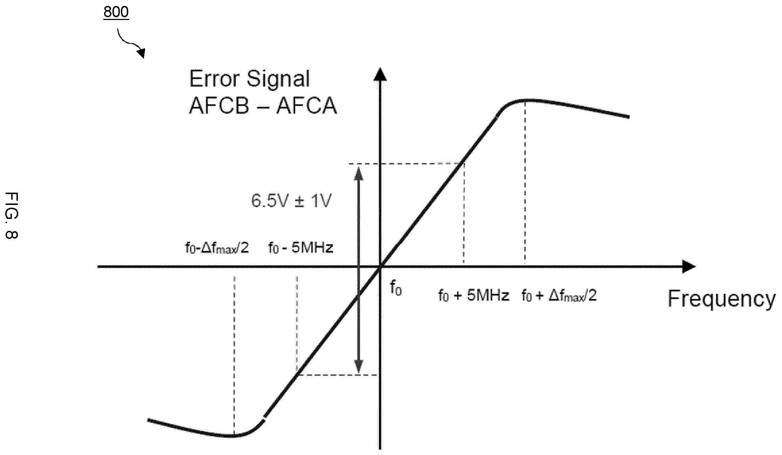

Figure 8 shows an example of a typical AFC error curve 800. The x-axis is the frequency difference between the magnetron (forward RF signal) and the accelerator frequency (reflected RF signal), the y-axis is the differential error signal AFC B - AFC A generated by the AFC module 700. As can be seen, the differential error signal acts in proportion to the phase difference of the two RF input signals. The differential error signal thus forms a reliable control variable. This differential error signal may be used to tune the magnetron's frequency to the resonant frequency of the accelerator. This means, if the RF frequency of the magnetron is working at the resonant frequency of the accelerator, AFC B - AFC A is around zero. Otherwise, AFC B - AFC A is in proportion to the phase difference of the magnetron frequency (forward RF signal) and accelerator frequency (reflected RF signal).

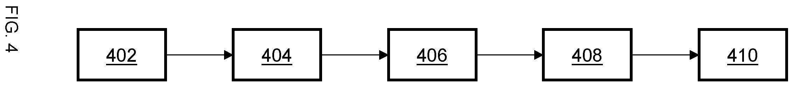

As described above, the discriminator 312 is part of the linac system. The discriminator (e.g. an AFC) receives a reflected RF signal and thus may act as or comprise a reflected RF probe. As shown in Figure 4, a reflected RF probe 402 receives a reflected RF (analog) signal and sends it to an attenuator 404, then a diode 406, then a differential amplifier 408 to convert the single ended reflected RF signal to a differential reflected RF signal. The differential signal is then converted to a digital signal using a differential analog-to-digital converter (ADC) 410. As such, an attenuator and a diode may be used to sample the RF reflected wave, converting the analog reflected RF signal to a digital RF signal. The digital RF signal may be sent to an MCU (microcontroller unit), which may form part of the BGC 314. The MCU may then monitor the reflected RF signal to detect arcing events.

One possible example of such a discriminator 312 is the AFT microwave mAFC-2998-01. One possible example of such a diode 406 is the Keysight 8470B diode. One possible example of such an amplifier 408 is the Analog Devices LTC6362 amplifier which is a low power, low noise differential op amp with rail-to-rail input and output swing that has been optimised to drive low power SAR ADCs (Successive Approximation Register ADCs). The amplifier 408 can change the single ended signal to a differential signal, which can then be input into the high-speed ADC. One possible example of such an ADC 410 is the Analog Devices AD9228 ADC which is a quad, differential input, 12-bit, 40-65 MSPS ADC. It can take 40 million samples per second so that the convert rate is enough to monitor the arcing. However, it should be appreciated that any suitable modules of a linac, such as discriminator, diode, amplifier and ADC, may be used to perform embodiments of the present invention.

### Arcing Detection

In a linac system (such as the system shown in Figures 1 and 3 and described above), commonly seen pulse signals include:
- Upstream pulse signals: magnetron voltage (referred to as CVD), magnetron current (referred to as CT);
- Midstream pulse signals: forward RF power, reflected RF power, electron gun current, phase discriminator's differential voltage; and
- Downstream pulse signal: primary dose current, secondary dose current.

Commonly seen non-pulse signals include:
- Accelerator waveguide vacuum level indicated by the ion pump current; and
- Various sensors readings including temperature, cooling water flow rate, SF6 pressure, etc.

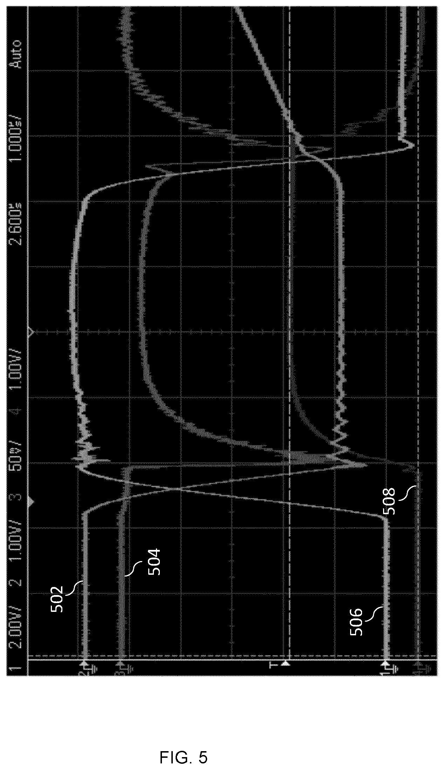

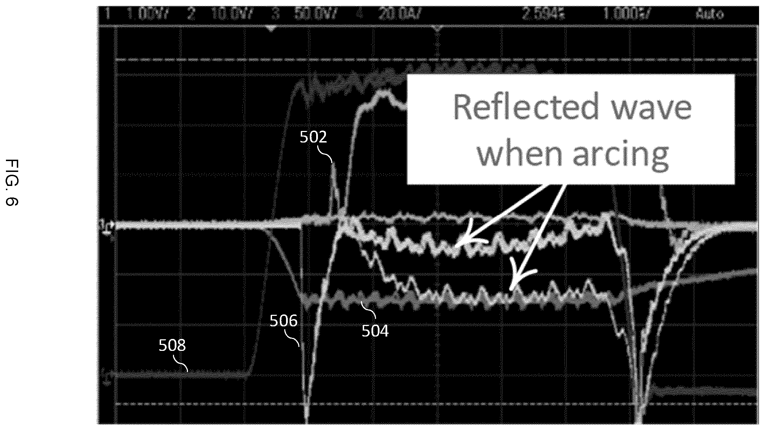

These pulse signals can be represented by waveforms. A "waveform" refers to the graphical representation of an electrical signal over time. Figure 5 shows example CT, CVD, e-gun current and RF reflected waveforms when arcing is not occurring, i.e. what the waveforms should look like when the linac is operating normally. Figure 5 shows the CVD waveform 502, the RF reflected waveform 504, the CT waveform 506 and the e-gun current waveform 508. In the example shown, the RF reflected waveform 504 comprises an envelope of 2998mHz, and the pulse width is around 4us. Figure 6 shows how signals 502, 504, 506, 508 may change when arcing is occurring. When arcing, the reflected RF signal 504 changes significantly. This signal 504 can be sampled using a high-speed analog-to-digital convertor, for example, as described above with reference to Figure 4, and monitoring the average of the RF reflected waveform. This allows arcing to be identified. The horizontal x-axis in both Figures 5 and 6 is time, each square corresponding to 1ms.

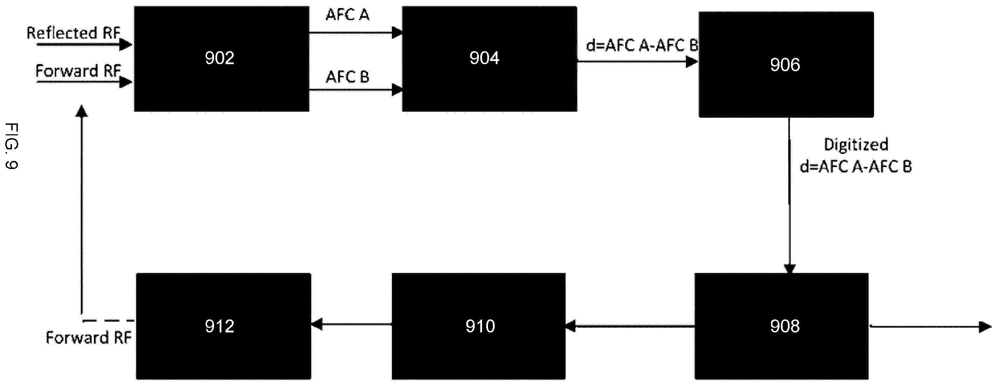

Figure 9 shows how the phase error (e.g. AFC B - AFC A or AFC A - AFC B depending on how the outputs are defined) can be used for arcing detection. A discriminator 312, 902, 700, receives the forward RF and reflected RF signals and outputs the two output signals (e.g. AFC A and AFC B signals), as described above with reference to Figure 7. An amplifier 904, e.g. amplifier 408, produces the phase error signal d = AFC B - AFC A (or AFC A - AFC B). The phase error signal d is then input into an ADC 906 which outputs a digitized phase error signal. The digitized phase error signal is input into an MCU 908, which may form part of the BGC 314. The MCU 908 serves two functions. Firstly, the MCU 908 outputs a signal to the tuner 910 (e.g. tuner driver 306) to tune the magnetron's 912 frequency to the resonant frequency of the accelerator such that the phase error signal is as close to zero as possible. Secondly, the MCU 908 monitors the phase error signal to detect arcing events. This may be done by monitoring d(n)-d(n-1), where d is the phase error signal and when time t=0, d is set to d(0). When t=1, d=d(1), and so on until t=(n-1), d=d(n-1) and t=n, d=d(n).

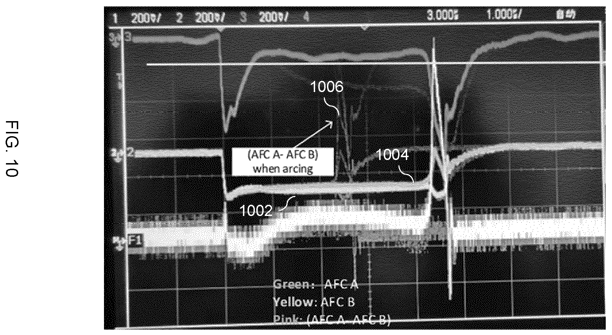

Figure 10 shows AFC A 1004, AFC B 1002, and (AFC A - AFC B) 1006 when arcing is occurring. As can be seen, (AFC A - AFC B) 1006 changes obviously because of the phase difference. Using this signal 1006, e.g. by sampling signal 1006 using a high-speed ADC, arcing can be identified.

Embodiments of the present invention provide different ways to detect arcing within a linac automatically using components of the linac itself. Embodiments of the present invention can be performed automatically using the discriminator 312 and the BGC 314. Examples of ways to automatically identify arcing using linac components are set out below.

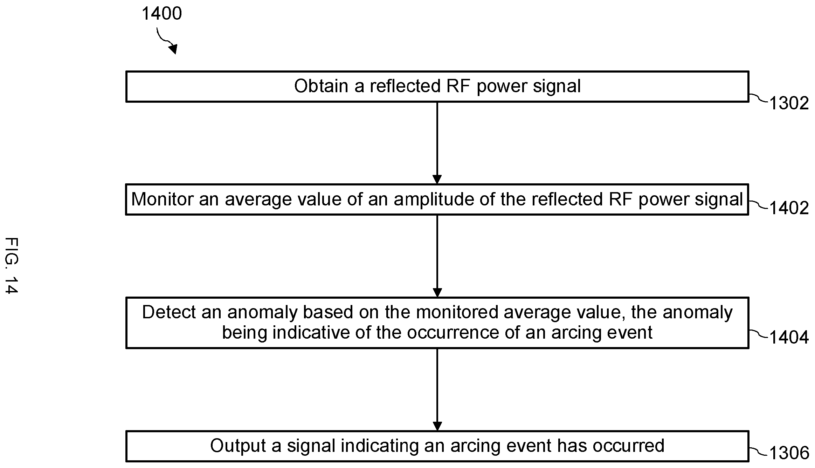

Firstly, by monitoring the amplitude of the reflected RF signal, arcing can be identified. The reflected RF signal may be sampled using an attenuator and a diode and then monitored by the BGC 314 as described in relation to Figure 4 above. This example is described below in relation to Figure 14.

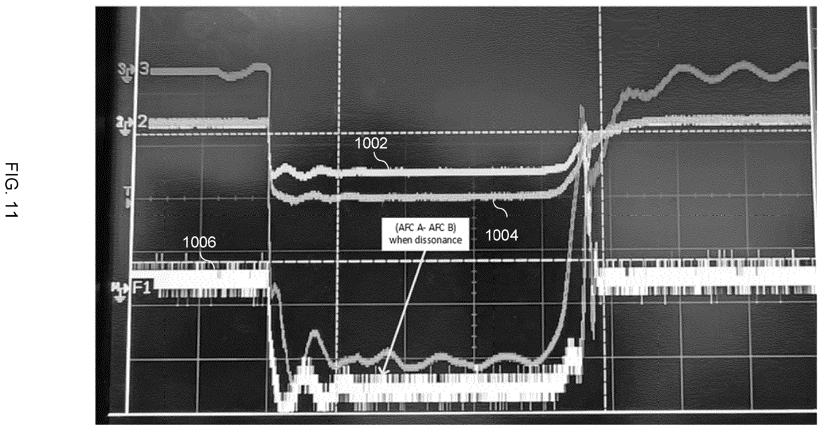

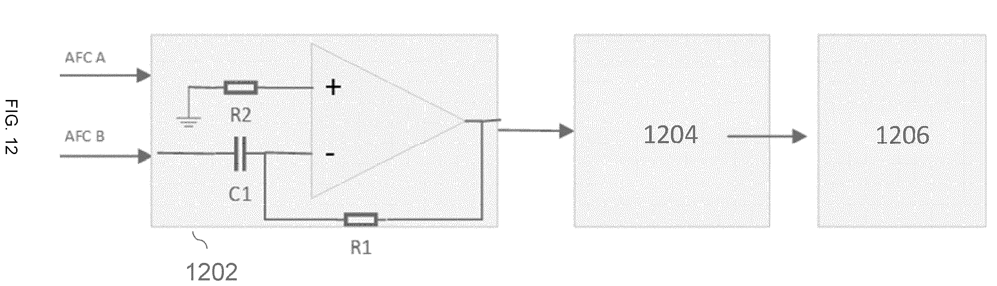

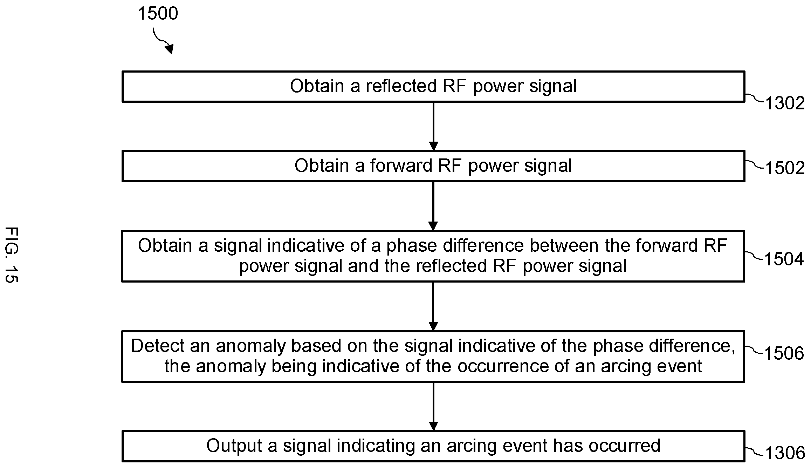

Secondly, arcing can cause a phase difference between the forward RF wave and the reflected RF wave, leading to a change in the amplitude of the phase error signal (AFC A - AFC B). By monitoring the amplitude (or average of the amplitude) of the phase error signal, arcing can be identified. This example is described below in relation to Figure 15. However, in some circumstances, a dissonance between the forward wave and the reflected wave may be intentional (rather than being caused by arcing). This intentional dissonance also causes a change in the average value of the phase error signal, as shown in Figure 11. Figure 11 shows AFC A 1004, AFC B 1002, and (AFC A - AFC B) 1006 when intentional dissonance occurs. As can be seen, (AFC A - AFC B) 1006 changes obviously from its baseline. To distinguish between arcing and intentional dissonance, a differential circuit may be used to collect a jump signal. One example of such a differential circuit is shown in Figure 12. Figure 12 shows signals AFC A and AFC B (i.e. from discriminator 312, 700, 902 as described above) being input into differential circuit 1202 to produce a jump signal. The jump signal is then processed by a differential ADC 1204 (e.g. ADC 410, 906 as described above) and output to the MCU 1206 (e.g. MCU 908 as described above). When the output amplitude of the differential circuit (i.e. the amplitude of the jump signal) exceeds a predetermined threshold, arcing can be identified as the cause of the phase difference. Intentional dissonance, on the other hand, is a stable signal which has a jump signal of zero.

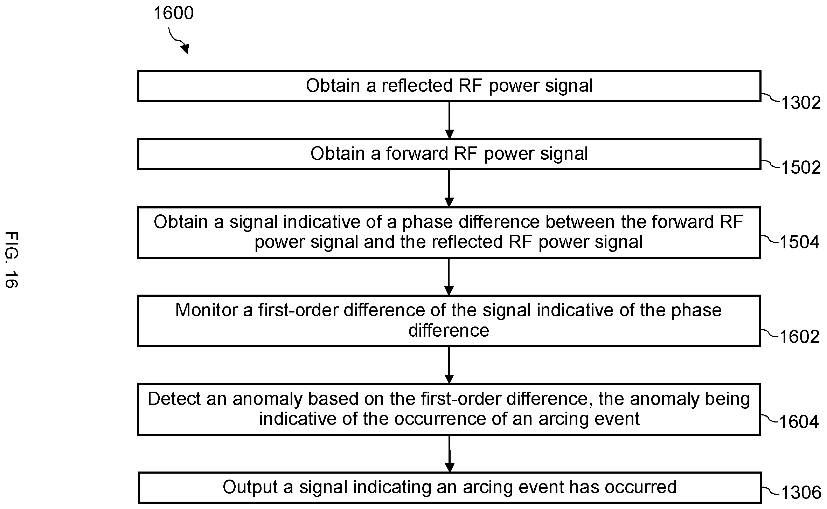

Thirdly, instead of requiring a differential circuit to distinguish between intentional dissonance and arcing, MCU FW (microcontroller firmware) may be used to process raw data sampled by the ADC 906 shown in Figure 9. This example is described below in relation to Figure 16. This means that d(n)-d(n-1) may be monitored rather than the average value of the phase error signal. In this way, the MCU FW can distinguish between the phase error caused by intentional dissonance of the forward wave and the reflected wave, and the phase error caused by arcing. When arcing is not occurring, e.g. during intentional dissonance, d(n)-d(n-1) is approximately zero. However, when arcing occurs, d(n)-d(n-1) is greater than zero. A predetermined threshold may be set to automatically determine whether arcing has occurred. For example, the threshold may be set at 0.5V. If d(n)-d(n-1) > 0.5V, the system may conclude that arcing has occurred. If d(n)-d(n-1) < 0.5V, the system may conclude that arcing has not occurred.

Figure 13 is a flow chart illustrating process steps in a method 1300 of detecting an arcing event within a radiotherapy linac. The method 1300 may be performed automatically by one or more modules of the linac (e.g. the BGC 314, the discriminator 312, the amplifier 408, 904, etc.).

Method 1300 comprises, in step 1302, obtaining a reflected RF power signal. This step may be performed by a reflected RF signal probe, e.g. as described in relation to Figure 4 above. In some examples, the reflected RF signal probe may be configured to send the reflected RF power signal to a discriminator 312 and/or a controller (e.g. a MCU and/or BGC 314).

Method 1300 comprises, in step 1304, detecting an anomaly based on the reflected RF power signal, the anomaly being indicative of the occurrence of an arcing event. For example, the anomaly indicative of the occurrence of the arcing event may be detected based on an amplitude of the reflected RF power signal itself, an average value of said amplitude, a further signal derived from the reflected RF power signal (e.g. the phase error signal (phase difference) described above or the d(n)-d(n-1) signal described above), etc. In some examples, step 1304 is performed by a MCU and/or the BGC 314.

Method 1300 comprises, in step 1306, outputting a signal indicating an arcing event has occurred. In some examples, step 1306 is performed by a MCU and/or the BGC 314. In some examples, the signal is output to a user, e.g. via a web GUI. The arcing event may comprise arcing in an RF power transmission path of the linac.

Figure 14 is a flow chart illustrating process steps in a method 1400 of detecting an arcing event within a radiotherapy linac. The method 1400 may be performed automatically by one or more modules of the linac (e.g. the BGC 314, the discriminator 312, the amplifier 408, 904, etc.).

Method 1400 comprises steps 1302, 1402, 1404 and 1306. Steps 1302 and 1306 are described above.

Step 1402 comprises monitoring an average value of an amplitude of the reflected RF power signal. This may comprise computing the average of the signal over a specific time window. This can be done using a moving average filter or by summing the amplitude values and dividing by the number of amplitude values.

Step 1404 comprises detecting an anomaly based on the monitored average value, the anomaly being indicative of the occurrence of an arcing event. For example, if the average value exceeds a predetermined threshold, arcing may be detected.

Figure 15 is a flow chart illustrating process steps in a method 1500 of detecting an arcing event within a radiotherapy linac. The method 1500 may be performed automatically by one or more modules of the linac (e.g. the BGC 314, the discriminator 312, the amplifier 408, 904, etc.).

Method 1500 comprises steps 1302, 1502, 1504, 1506 and 1306. Steps 1302 and 1306 are described above.

Step 1502 comprises obtaining a forward RF power signal. This step may be performed by a forward RF signal probe positioned after the magnetron. The forward RF signal probe may be connected from a coupler positioned after the magnetron, for example, a non-directional coupler. In some examples, the forward RF signal probe may be configured to send the forward RF power signal to a discriminator 312 and/or a controller (e.g. a MCU and/or BGC 314).

Step 1504 comprises obtaining a signal indicative of a phase difference between the forward RF power signal and the reflected RF power signal. In some examples, the signal indicative of the phase difference may be obtained using a discriminator 312 (e.g. AFC module 700). In such a case the reflected RF power signal and the forward RF power signal are sent to the discriminator (in some examples by the reflected and forward RF signal probes), which processes the reflected RF power signal and the forward RF power signal and outputs a first output signal and a second output signal (e.g. AFC A and AFC B described above). The signal indicative of the phase difference may then be obtained by calculating a difference between the second output signal and the first output signal (e.g. AFC B - AFC A). Calculating the difference may be performed by an amplifier (e.g. amplifier 408, 904). The amplifier may output the signal indicative of the phase difference to a controller (e.g. BGC 314, MCU 908). The controller may be configured to detect the anomaly.

In some examples, the method 1500 further comprises monitoring an average value of an amplitude of the signal indicative of the phase difference. In such a case, the anomaly indicative of the occurrence of the arcing event may be detected based on the monitored average value. Monitoring the average value may comprise computing the average of the signal over a specific time window. This can be done using a moving average filter or by summing the amplitude values and dividing by the number of amplitude values.

Step 1506 comprises detecting an anomaly based on the signal indicative of the phase difference, the anomaly being indicative of the occurrence of an arcing event. For example, if the average value exceeds a predetermined threshold, arcing may be detected.

In some examples, step 1506 may comprise inputting the first and second output signals from the discriminator as described above (e.g. AFC A and AFC B) into a differential circuit (e.g. differential circuit 1202 to obtain a jump signal. If the jump signal's amplitude is greater than a predetermined threshold, this means the phase difference results from arcing, allowing the conclusion that arcing has occurred. If the jump signal's amplitude is less than a predetermined threshold, this means that the phase difference results from intentional dissonance, allowing the conclusion that arcing has not occurred. The comparison of the jump signal's amplitude to the predetermined threshold may be performed by a controller of the linac (e.g. MCU 904, BGC 314).

Figure 16 is a flow chart illustrating process steps in a method 1600 of detecting an arcing event within a radiotherapy linac. The method 1600 may be performed automatically by one or more modules of the linac (e.g. the BGC 314, the discriminator 312, the amplifier 408, 904, etc.).

Method 1600 comprises steps 1302, 1502, 1504, 1602, 1604 and 1306. Steps 1302, 1502 1504 and 1306 are described above.

Step 1602 comprises monitoring a first-order difference of the signal indicative of the phase difference. The first-order difference may comprise a difference between the signal indicative of the phase difference at time n, and the signal indicative of the phase difference at time n-1, i.e. d(n)-d(n-1) as described above in relation to Figure 9.

Step 1604 comprises detecting an anomaly based on the first-order difference, the anomaly being indicative of the occurrence of an arcing event. For example, if d(n)-d(n-1) exceeds a predetermined threshold, arcing may be detected.

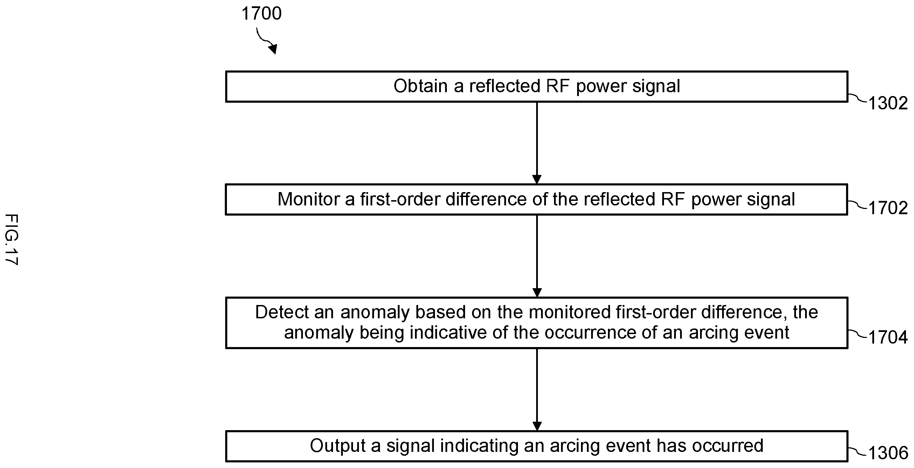

Figure 17 is a flow chart illustrating process steps in a method 1700 of detecting an arcing event within a radiotherapy linac. The method 1700 may be performed automatically by one or more modules of the linac (e.g. the BGC 314, the discriminator 312, the amplifier 408, 904, etc.).

Method 1700 comprises steps 1302, 1702, 1704 and 1306. Steps 1302 and 1306 are described above.

Step 1702 comprises monitoring a first-order difference of the reflected RF power signal. The first-order difference may comprise a difference between the reflected RF power signal at time n, and the reflected RF power signal at time n-1, i.e. d(n)-d(n-1).

Step 1704 comprises detecting an anomaly based on the first-order difference, the anomaly being indicative of the occurrence of an arcing event. For example, if d(n)-d(n-1) exceeds a predetermined threshold, arcing may be detected.

While certain embodiments have been described, these embodiments have been presented by way of example only, and are not intended to limit the scope of the inventions. Indeed, the novel methods and apparatuses described herein may be embodied in a variety of other forms; furthermore, various omissions, substitutions and changes in the form of methods and apparatus described herein may be made.

## Claims

1. A method of detecting an arcing event within a radiotherapy linear accelerator, linac, the method comprising:
obtaining a reflected radiofrequency, RF, power signal;
detecting an anomaly based on the reflected RF power signal, the anomaly being indicative of the occurrence of an arcing event; and
outputting a signal indicating an arcing event has occurred.

2. The method of claim 1, wherein the linac comprises one or more modules, and the method is performed automatically by the one or more modules of the linac.

3. The method of claim 1 or 2, wherein the anomaly indicative of the occurrence of the arcing event is detected based on an amplitude of the reflected RF power signal.

4. The method of claim 3, the method further comprising monitoring an average value of an amplitude of the reflected RF power signal, and wherein the anomaly indicative of the occurrence of the arcing event is detected based on the monitored average value.

5. The method of claim 1 or 2, the method further comprising:
obtaining a forward RF power signal; and
obtaining a signal indicative of a phase difference between the forward RF power signal and the reflected RF power signal; and
wherein the anomaly indicative of the occurrence of the arcing event is detected based on the signal indicative of the phase difference.

6. The method of claim 5, the method further comprising monitoring an average value of an amplitude of the signal indicative of the phase difference, and wherein the anomaly indicative of the occurrence of the arcing event is detected based on the monitored average value.

7. The method of claim 1 or 2, the method further comprising:
obtaining a forward RF power signal;
obtaining a signal indicative of a phase difference between the forward RF power signal and the reflected RF power signal; and
monitoring a first-order difference of the signal indicative of the phase difference, and wherein the anomaly indicative of the occurrence of the arcing event is detected based on the first-order difference.

8. The method of claim 7, wherein the first-order difference comprises a difference between the signal indicative of the phase difference at time n, and the signal indicative of the phase difference at time n-1.

9. The method of any one of claims 5 to 8, the method further comprising inputting the reflected RF power signal and the forward RF power signal into a discriminator, which processes the reflected RF power signal and the forward RF power signal and outputs a first output signal and a second output signal;
wherein the signal indicative of the phase difference is obtained by calculating a difference between the second output signal and the first output signal.

10. The method of claim 9, wherein the detecting of the anomaly indicative of the occurrence of the arcing event in the signal indicative of the phase difference comprises:
inputting the first and second output signals into a differential circuit to obtain a jump signal; and
determining that an amplitude of the jump signal exceeds a predetermined threshold.

11. The method of any preceding claim, wherein the arcing event comprises arcing in a RF power transmission path of the linac.

12. The method of any preceding claim, wherein the signal indicating an arcing event has occurred is output to a user.

13. A computer program comprising instructions which, when the program is executed by a computer, cause the computer to carry out the method of any of the preceding claims.

14. A computer-readable medium comprising instructions which, when executed by a computer, cause the computer to carry out the method of any of claims 1 to 12.

15. A radiotherapy linear accelerator, linac, system comprising:
one or more modules collectively configured to perform the method of any of claims 1 to 12.

16. A radiotherapy linear accelerator, linac, system comprising one or more modules collectively configured to:
obtain a reflected radiofrequency, RF, power signal;
detect an anomaly based on the reflected RF power signal, the anomaly being indicative of the occurrence of an arcing event; and
output a signal indicating an arcing event has occurred.

17. The system of claim 16, wherein the one or more modules comprise a reflected RF signal probe configured to obtain the reflected RF power signal.

18. The system of claim 17, wherein the one or more modules further comprise a forward RF signal probe configured to obtain a forward RF power signal.

19. The system of claim 18, wherein the one or more modules further comprise a discriminator, an amplifier and a controller; and wherein:
the forward RF signal probe and the reflected RF signal probe are configured to send the forward RF power signal and the reflected RF power signal to the discriminator;
the discriminator is configured to process the forward RF power signal and the reflected RF power signal and output a first output signal and a second output signal;
the amplifier is configured to calculate a difference between the second output signal and the first output signal to obtain a signal indicative of the phase difference between the forward RF power signal and the reflected RF power signal, and to output the signal indicative of the phase difference to the controller;
the controller is configured to detect the anomaly indicative of the occurrence of the arcing event in the signal indicative of the phase difference, and to output the signal indicating an arcing event has occurred.

20. The system of claim 19, wherein the one or more modules further comprise a differential circuit, and wherein:
the differential circuit is configured to receive the first and second output signals from the discriminator and obtain a jump signal; and
the controller is configured to receive the jump signal from the differential circuit and determine that an amplitude of the jump signal exceeds a predetermined threshold.

21. The system of claim 19 or 20, wherein the controller is a microcontroller unit, MCU.

22. The system of any of claims 19 to 21, wherein the controller is a beam generation controller of the linac.
